# EUROPÄISCHE PATENTSCHRIFT

(11) **EP 2 272 311 B1**
(45) Veröffentlichungstag und Bekanntmachung des Hinweises auf die Patenterteilung: **26.10.2016**
(21) Anmeldenummer: 09737728.7
(22) Anmeldetag: 27.04.2009
(51) Int. Cl.: H05K 7/20, H01L 23/46

(54) **KÜHLVORRICHTUNG FÜR EINE MEHRZAHL VON LEISTUNGSMODULEN**
COOLING DEVICE FOR A PLURALITY OF POWER MODULES
DISPOSITIF DE REFROIDISSEMENT POUR UNE PLURALITÉ DE MODULES DE PUISSANCE

(30) Priorität: 02.05.2008 DE 102008021917
(43) Veröffentlichungstag der Anmeldung: 12.01.2011
(73) Patentinhaber: Danfoss Silicon Power GmbH, 24941 Flensburg (DE)
(72) Erfinder: OLESEN, Klaus Kristen, DK - 6400 Soenderborg (DK); PAULSEN, Lars, 25788 Hollingstedt (DE); KLINGHAGEN, Jens, 24988 Munkwolstrup (DE)
(74) Vertreter: Lobemeier, Martin Landolf
(86) Internationale Anmeldenummer: PCT/DE2009/000561
(87) Internationale Veröffentlichungsnummer: WO 2009/132620

(56) Entgegenhaltungen:
- EP-A- 1 113 496
- WO-A-2006/056199
- DE-A1- 10 358 641
- DE-A1- 19 956 565

## Beschreibung

Die Erfindung betrifft eine Kühlvorrichtung für eine Mehrzahl von Leistungsmodulen nach dem Oberbegriff des Hauptanspruches.

Bei Kühlvorrichtungen wie sie beispielsweise aus der DE 103 58 641 A1 bekannt sind, ist die Gestaltung des Kühlers sehr aufwendig, daher kostenintensiv und die Montage der einzelnen Module kompliziert. Weiter tritt hier das Problem auf, dass die Kühlwirkung nicht homogen über alle Module gleichmäßig erreicht wird.

Eine Alternative, die Direktkühlung, hat den Nachteil, dass eine Abdichtung der wasserführenden Bereiche in der Nähe der Elektronik notwenig ist, und aufgrund Einsatzbedingungen mit langen Standzeiten von Elektronik und dem hohen Schaden den ihr Ausfall bedeuten kann, die Gefahr möglicher Leckagen bisher im Stand der Technik dazu führte, dass meist von einem offenen Wasserkühler abgesehen wurde. Die klassische Methode mit einer Kühlplatte erlaubt nur die ebene Anordnung von Modulen und benötigt damit eine ganz erheblich größere Grundfläche als ein gestapelter Aufbau. Außerdem ist hier wieder die Modulmontage aufwendig.

Die US 6,542,365 B2 beschreibt bereits Kühlschlangen mit elastischen Abschnitten, wobei Halbleitereinrichtungen zwischen mittleren und Endabschnitten der Kühlschlangen gehaltert sind. Diese komplexen Strukturen weisen erhöhte Leckrisiken auf, weil die Kühlmittelkanäle vielfach gebogen und mechanischen Einflüssen ausgesetzt sind. Diese Anordnungen sind aufgrund Ihrer Komplexität zudem nur mit hohen Kosten herstellbar.

Weiter sind die WO 2006/056199 A, die DE 103 58 641 A1, die EP-A-1 113 496 und die DE 199 56 565 A1 zu nennen, in denen flache Kühlelemente bzw. eine Kühlvorrichtung mit flachen Kühlungsrohren und eine Kühlvorrichtung, die mit die Kühlungskanäle bildende Öffnungen versehen ist, beschrieben sind.

Schließlich ist noch die EP 1 815 514 B1 der Anmelderin zu nennen, die bereits ein Durchflussverteilmodul betrifft, wobei Substrate von Leistungsmodulen in Hohlräumen des Gehäuses angeordnet werden. Spezielle Einlaßverteiler und Auslaßverteiler schaffen Durchflußverbindungen. Aufgrund der gleichen Geometrie der Module sind sie mit gleichem Strömungswiderstand ausgestattet, so daß bei einer gewissen Entfernung, d.h. bei vielen Modulen, es zu unterschiedlichen Durchflußmengen aufgrund der verschieden hohen Partialdrücke im jeweiligen Einlaß kommen kann.

Die Erfindung hat sich daher zur Aufgabe gestellt, eine Kühlvorrichtung zu schaffen, die einen gestapelten Aufbau einer Mehrzahl von Leistungsmodulen im platzsparender und einfach zu montierender Weise ermöglicht, und dabei gleichzeitig eine gleiche Kühlleistung an allen Modulen in sicherer Weise ohne die Gefahr von Leckagen ermöglicht.

Erfindungsgemäß wird dies durch die Merkmale des Hauptanspruches gelöst. Die Unteransprüche geben vorteilhafte Ausführungen der Erfindung wieder.

Insbesondere dadurch, dass die Kühlvorrichtung an einer Seite zur benachbarten Aufnahme der Mehrzahl von Leistungsmodulen mit Kühlrippen versehen ist, wobei jede einzelne Kühlrippe dazu eingerichtet ist, an wenigstens die Ober- oder Unterseite eines aus der Mehrzahl von Leistungsmodulen in festen wärmeleitenden Kontakt zu treten ist bereits eine sehr platzsparende Anordnung möglich, die dann, wenn mittlere Kühlrippen dazu eingerichtet sind, an eine Ober- und an die Unterseite eines benachbarten Leistungsmoduls angedrückt zu werden, diese besonders gut kontrollieren kann. Dabei ist zu berücksichtigen, dass die Endrippen selbstverständlich jeweils nur ein Leistungsmodul kühlen werden und das Leistungsmodule auch so angeordnet werden können, dass die Oberseite zur Oberseite bzw. die Unterseite zur Unterseite ausgerichtet sind, sofern man überhaupt eine klare Definition von der Ober- und Unterseite bei den Leistungselektroniken treffen kann.

Die Andruckkraft wird mittels eines Keils auf die Leistungselektronik-Module aufgebracht werden können, so dass sich die Notwendigkeit ergibt, jedenfalls die Endrippen mechanisch besonders abzustützen, wie dies beispielsweise durch Stützrippen geschehen kann, die nicht direkt im Kontakt mit Leistungselektronik-Modulen stehen, aber im rechten Winkel zu der oder den Endrippe(n) diese gegen Verbiegen nach außen schützen.

Durch die einfache stapelförmige Anordnung der Module ist es weiterhin möglich, eine einfache induktivitätsarme Verschienung zu realisieen. und Sie gemeinsam mechanisch gegen ein Verrutschen - auch der Keile - zu sichern.

Weiter ergibt sich der Vorteil, dass die Dichtung für die Wasserkühlung auf der modulabgewandten Seite räumlich weit getrennt von den elektronischen Komponenten erfolgen kann, so dass eine Einfügung von mehreren Dichtschichten möglich ist. Trotzdem ergibt sich ein kompakter platzsparender Aufbau mit einer einfachen Montage, da alle Modulschnittstellen gut sichtbar sind.

Durch die parallele Anordnung ergibt sich ein optimierbare Kühlmittelverteilung, die weiter durch Kunststoffeinsätze im die Rippen tragenden Stegbereich der Kühlvorrichtung noch optimierbar ist. Da in jede Kühlzelle das Kühlmedium mit der gleichen Temperatur eintritt, ergibt sich eine homogene Kühlung gegenüber den Anordnungen im Stand der Technik, in dem das Kühlmittel mehrere nacheinander geschaltete Kühlvorrichtungen durchfließt.

Benachbarte Anordnung der Stapelmodule bedeutet in diesem Fall, dass diese parallel zueinander in einer Reihe mit den Flachseiten aufeinanderzuweisend wie ein Stapel ausgerichtet sind. Die Rippen weisen dabei vorteilhafter Weise ungefähr die gleichen Dimensionen wie ein Leistungsmodul auf, wobei sie jedoch aufgrund der in Ihnen bevorzugt vorgesehenen Einschubstücke für kanalbildende Wände sie dicker als dieses ausgeführt. Ein Überstand über die Dimensionen des Leistungsmoduls würde die Montage etwas erschweren, andererseits jedoch die Anschlüsse unter Umständen mechanisch in vorteilhafter Weise schützen.

Durch Keile, die wiederum vorteilhafterweise mit entsprechenden Führungsschienen in den Leistungsmodulen korrespondierend ausgebildet sind, die durch einen über alle Rippen hinweg mit Schrauben fixierbaren Abschlusssteg fixiert werden können, lässt sich ein wärmeleitender fester Kontakt der Leistungsmodule in der Kühlvorrichtung erreichen. Das Material der Keile kann dabei wie das Material der Module an die Ausdehnung der Kühlvorrichtung, insbesondere des die Rippen tragenden Grundsteges angepasst sein.

Die einzelnen Rippen können abnehmbar gestaltet sein, beispielsweise durch Schrauben befestigt werden oder sie können integraler Bestandteil eines Deckels eines Wasserreservoirs sein, wobei in einer weiteren bevorzugten Ausführungsform sie innen hohl zur Aufnahme von Wasserkanäle ausbildenden Blättchen ausgebildet sein können. Sie können aber auch Heatpipes aufnehmen oder aus besonders leitendem Material erstellt sein.

Die Anbindung der Module an den dreidimensionalen Kühlkörper mittels Pressung auf eine TIM (Thermal Interface-Material)-Schicht wird bevorzugt, es können jedoch Verbindungen mittels Kleben, Löten oder Drucksintern ebenfalls vorgesehen werden. Dafür gibt es wiederum geeignete Verbindungsmaterialien und Beschichtungen, die aus der Löt- bzw. Drucksintertechnik bekannt sind, d. h., ein AlSiC-Kühlkörper mit einer Ni-Beschichtung bzw. drucksinterfähige Oberflächen. Eine solche stoffschlüssige Verbindung würde zu einer besonders vorteilhaften Wärmeleitung gegenüber der vorab geschilderten TIM-Schicht-Ausführung führen, und ist damit für Anwendungsfälle prädestiniert, bei denen besonders hohe Kühlleistungen der Module ermöglicht werden sollen.

Für eine gelötete Ausgestaltungsvariante ist es ersichtlicherweise nicht erforderlich, die Module mit einem Moldkörper zu schützen, weil auf eine Keil-Pressung verzichtet werden kann.

Weitere Vorteile und Merkmale der Erfindung ergeben sich aus nachfolgender Beschreibung eines bevorzugten Ausführungsbeispiels. Dabei zeigt:
- Fig. 1: den erfindungsgemäßen Aufbau im zusammengefügten Zustand.
- Fig. 2: die in Fig. 1 nicht erkennbaren, weil innen vorgesehenen dargestellten Merkmale, nämlich die in den einzelnen Kühlrippen von unten eingeschobenen Blättchen.
- Fig. 3: ein Unterteil, das zur Kühlmittelzu- und -abfuhr dienen kann,
- Fig. 4, 5 und 6: zeigen den erfindungsgemäßen Aufbau von der Seite, Der Stirnseite und von oben, wobei der die Keile fixierende Steg gut erkannt werden kann,

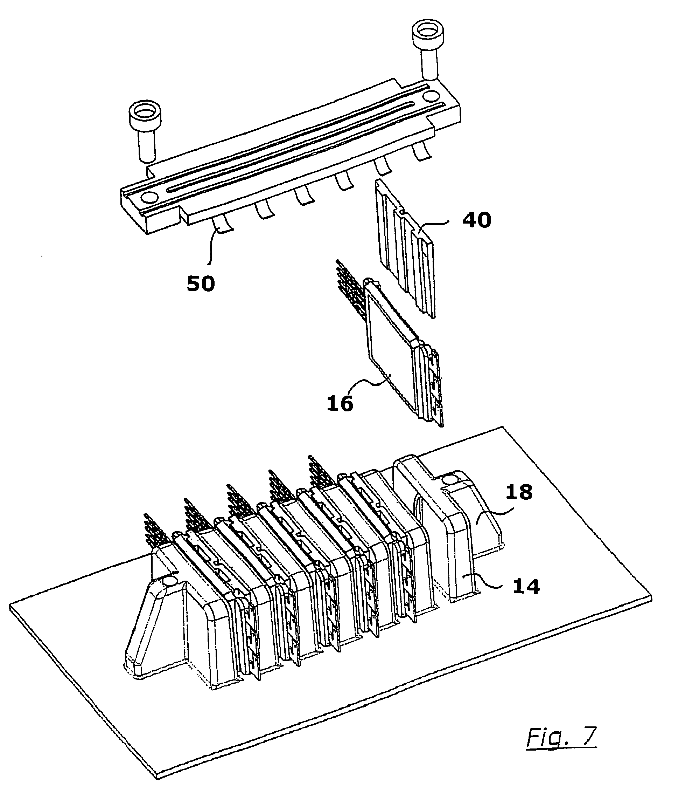

- Fig. 7: schematisch eine Montage eines Leistungsmoduls, wobei ein letztes Kühlelement zwischen einem verbleibenden Freiraum zwischen der letzten und der Endrippe eingebracht, und daraufhin ein Keil von oben her eingeschoben und ein Steg zur Fixierung aufgeschraubt wird. Von unten hin wird in Kühlrippe noch ein Kanäle ausbildendes Blättchen eingebracht.
- Fig. 8: eine Darstellung auf die in Fig. 7 nicht sichtbare Rückseite, die den Einschub strukturierter, passende Einschübe in die Hohlräume der Kühlrippen zeigt.

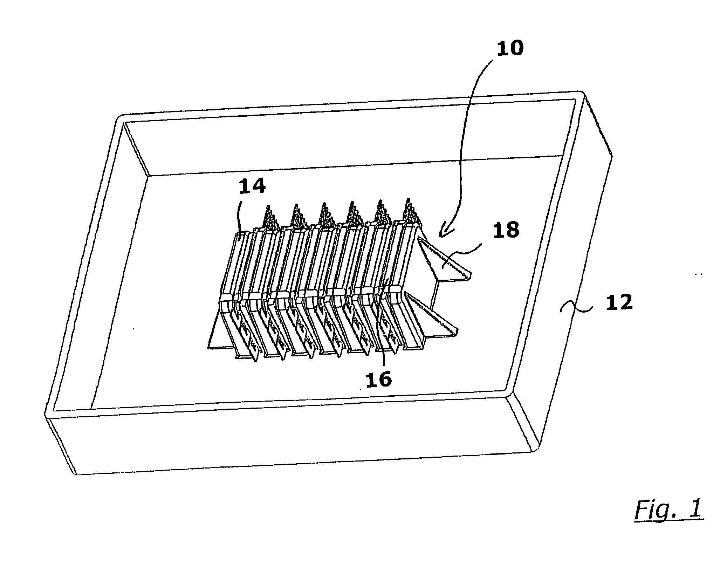

Der in Fig. 1 um die Kühlvorrichtung 10 herum erkennbare äußere Rahmen 12 dient zur Beherbergung weiterer Komponenten.

Die Vorrichtung und insbesondere die einzelnen Kühlrippen 14, die parallel sich zu diesen erstreckend jeweils benachbart jedes Leistungsmoduls 16 angeordnet sind, sind etwa gleich hoch wie die Leistungsmodule, um alle Bereich in denen Wärme entstehen kann, eng zu kontaktieren.

Beispielhaft werden in der Zeichnung sechs Leistungsmodule 16 von sieben Kühlrippen 14 umgeben und die jeweils äußeren Kühlrippen 14 besitzen noch jeweils zwei Abstützkanten 18. Als Material wird für den Kühlkörper Aluminium vorgeschlagen, andere Materialien sind denkbar.

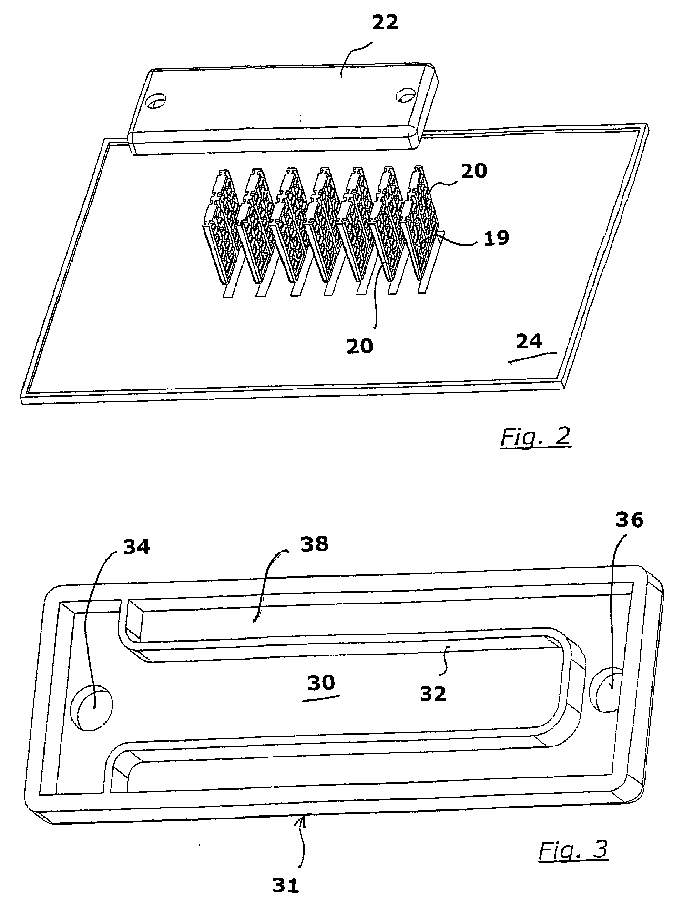

Nicht in der Fig. 1 zu erkennen sind die in der Fig. 2 dargestellten Merkmale, nämlich die in den einzelnen Kühlrippen von unten eingeschobenen Blättchen 20 zur Ausbildung von Kühlmittelkanälen und ein oberhalb der Rippen mit Schraubbolzenverbindungen zur Fixierung von Keilen angeordnete Abdecksteg 22.

Die Kühlvorrichtung besitzt gut erkennbar außen an einer ersten Gehäuseschale 24 des kühlmitteldurchflossenen Körpers 15 mehrere Kühlrippen 14 zur Aufnahme der Mehrzahl von Leistungsmodulen 16 (bevorzugt je eines zwischen zwei Kühlrippen 14), wobei jede einzelne Kühlrippe 14 dazu eingerichtet ist, an wenigstens die Ober- oder Unterseite eines aus der Mehrzahl von Leistungsmodulen 16 in festen wärmeleitenden Kontakt zu treten, und die Gehäuseschale auf der Innenseite im Bereich der jeweiligen Kühlrippe(n) 14 Mittel zur Flüssigkeitskommunikation mit dem Volumen des im Inneren des kühlmitteldurchflossenen Körpers befindlichen Kühlmittels besitzt.

In der Fig. 3 wird schließlich ein Unterteil, eine zweite Gehäuseschale 31, die zur Kühlmittelzu- und -abfuhr-Leitung dient, beispielhaft dargelegt. Durch Stege 32, die in den Innenraum hineinragen, ist der an einer Seite rückwärtig vorgesehene Ein-/Auslass 34 mit einem Mittenbereich 30 des Deckels in Flüssigkeitskommunikation während er von einem Randbereich 38 abgetrennt ist. Der Randbereich 38, der mit dem Aus- /Einlaß 36 an der anderen Schmalseite der Gehäuseschale 31 verbunden ist, erstreckt sich an beiden Längsseiten bis fast zum Ende. Flüssigkeitskommunikation zwischen Rand- 38 und Mittenbereich 30 wird nur über die innen hohlen Kühlrippen 14 ermöglicht, die beide Bereiche überlappen. Durch Strukturen 20 innerhalb der Kühlrippen 14 wird das Kühlmittel zusätzlich noch in alle Bereiche der Kühlrippen 14 geführt, bevor es diese wieder verlassen kann.

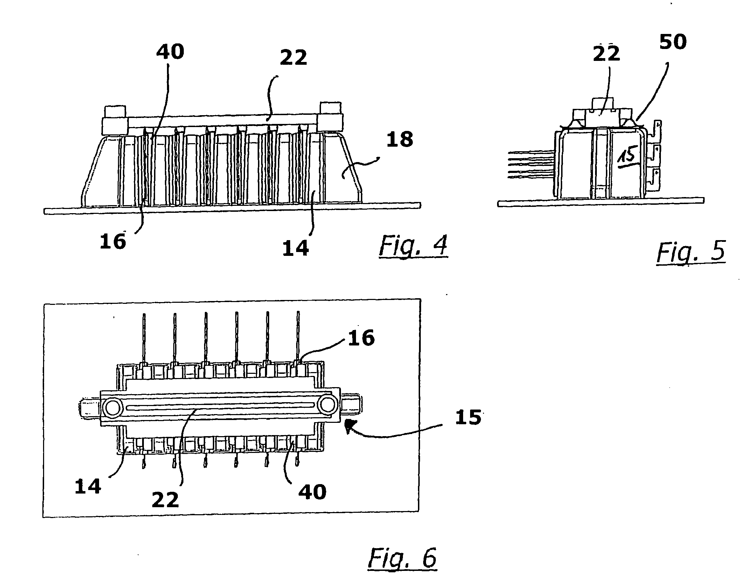

Die Fig. 4 zeigt den erfindungsgemäßen Aufbau von der Seite, wobei der die Keile 40 fixierende Steg 22 gut erkannt werden kann.

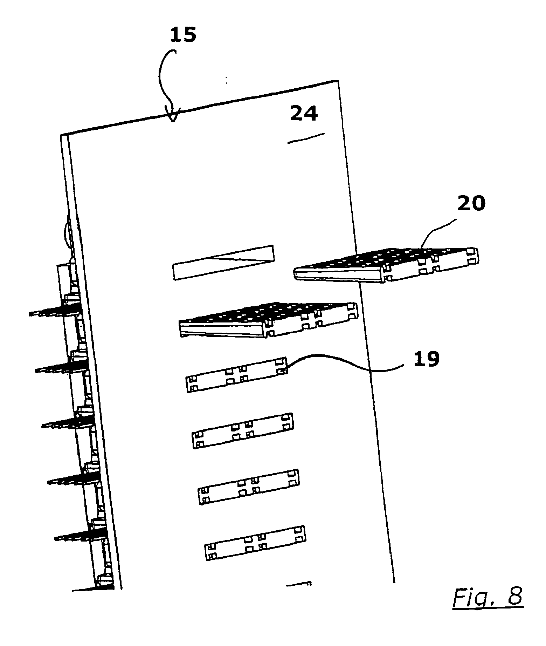

In der Fig. 5 wird der Zusammenbau schematisch dargestellt, wobei ein letztes Kühlelement zwischen einem verbleibenden Freiraum zwischen der letzten und der Endrippe eingebracht, daraufhin ein Keil 40 von oben her eingeschoben und ein Steg 22 zur Fixierung aufgeschraubt wird. Unter dem Steg 22 sind Federelemente 50 erkennbar, die jeweils einen Keil 40 federnd eindrücken, so daß dieser den thermischen Kontakt der Leistungsmodule mit den Kühlrippen sicherstellt. Von unten hin wird in Kühlrippe noch, wie in Fig. 2 dargestellt, ein Kanäle ausbildendes Blättchen 20 eingebracht (Fig. 8).

Die neben den Leistungsmodulen vorgesehenen Keile zur Klemmbefestigung gekapselter Leistungsmodule werden mit einer Federwirkung zur Bewirkung eines elastischen Daueranpreßdrucks durch beispielsweise einen im Herstellungsprozeß ausgewölbten Flachabschnitt versehen. Neben dem Kleben und oder Verklemmen können die Module auch durch Löten, Schweißen oder Drucksintern oder ähnliche Techniken befestigt werden. Es ist auch möglich federnde Abschnitte mit einer dieser Techniken direkt an die Kühlrippen anzubringen.

Damit weist die Kühlvorrichtung für eine Mehrzahl von Leistungsmodulen in ihrer einfachsten Ausgestaltung einen wärmeleitenden kühlmitteldurchflossenen Körper auf, wobei die Kühlvorrichtung an einer Seite zur benachbarten Aufnahme der Mehrzahl von Leistungsmodulen eine entsprechende Kühlrippen aufweist, wobei jede einzelne Kühlrippe dazu eingerichtet ist, an wenigstens die Ober- oder Unterseite eines der Leistungsmodule in festem wärmeleitenden Kontakt zu treten. Das heißt bevorzugt sind mittlere Kühlrippen dazu eingerichtet, außer mit der Ober- oder Unterseite eines aus der Mehrzahl von Leistungsmodulen ebenso mit einer weiteren Ober- oder Unterseite eines benachbarten aus der Mehrzahl von Leistungsmodulen in festem wärmeleitenden Kontakt zu treten.

Dabei werden in einer bevorzugten Ausführung die Leistungsmodule, parallel zueinander ausgerichtet, stapelartig beherbergt werden, so daß die elektrischen Anschlüsse der Leistungsmodule seitlich zwischen den Rippen herausragen.

Eine Symmetrie der Geometrie der Kühlrippen mit einer Höhe und Breite über einem von Kühlmittel durchflossenen Grundgehäuse, die den jeweiligen Abmessungen der Leistungsmodule entspricht, wird bevorzugt.

Dabei können einzelne Kühlrippen abnehmbar an der Kühlvorrichtung befestigt werden, und mit separaten Kühlmittelein- und auslässen für die Kühlmittelkanäle 17 versehen sein.

Weiter können Kühlrippen 14 innen hohl zur Aufnahme eines mit einem Flüssigkeitsgänge bildenden Reliefs versehenen Einschubblättchen versehen sein, insbesondere zur Zwangsführung von Kühlmittel durch die Rippen.

Die jeweils letzten einer Reihe benachbarter Kühlrippen mit Querversteifungsrippen können zur Aufnahme von Klemmkräften der Leistungsmodule zwischen den Rippen versehen werden. Dabei ist es denkbar, dass mehrere Reihen von Kühlrippen vorgesehen werden. Schließlich wird vorgeschlagen, dass zwischen je zwei Kühlrippen neben den Leistungsmodulen Keile zur Klemmbefestigung gekapselter Leistungsmodule bei der Montage genutzt werden. Diese können aus Kunststoff oder auch aus einem gut wärmeleitenden Material bestehen.

## Patentansprüche

1. Kühler zum Kühlen einer Mehrzahl von elektrischen Leistungsmodulen (16) mit einem wärmeleitenden Körper (15), der von einem Kühlmittel durchströmbare Kanäle aufweist, **dadurch gekennzeichnet, daß**
der Körper (15) auf einer Seite rippenförmige Kühlelemente (14) aufweist, wobei jedes rippenförmige Kühlelement (14) mit wenigstens der Ober- oder Unterseite eines aus der Mehrzahl von zu kühlenden elektrischen Leistungsmodulen (16) Wärme leitend verbindbar ist, und
der Körper (15) auf einer anderen Seite Kühlmittelzu- und - abfuhr-Leitungen (31) aufweist, die mit dem das Innere der Kanäle durchströmbaren Kühlmittel in Verbindung bringbar sind.

2. Kühlvorrichtung nach Anspruch 1, **dadurch gekennzeichnet, daß** mittlere Kühlrippen (14) dazu eingerichtet sind, sowohl mit der Ober- oder Unterseite eines aus der Mehrzahl von Leistungsmodulen (16) wie weiter mit einer weiteren Ober- oder Unterseite eines benachbarten aus der Mehrzahl von Leistungsmodulen in festen wärmeleitenden Kontakt zu treten.

3. Kühlvorrichtung nach Anspruch 1 oder 2, **dadurch gekennzeichnet, daß** die Leistungsmodule parallel zueinander ausgerichtet, stapelartig beherbergt werden, so daß die elektrischen Anschlüsse der Leistungsmodule seitlich zwischen den Kühlrippen (14) herausragen.

4. Kühlvorrichtung nach einem der vorangehenden Ansprüche, **dadurch gekennzeichnet, dass** einzelne Kühlrippen (14) abnehmbar an der Kühlvorrichtung befestigt sind, und mit separaten Kühlmittelein- und auslässen versehen sind.

5. Kühlvorrichtung nach einem der vorangehenden Ansprüche, **dadurch gekennzeichnet**, das die Kühlrippen (14) eine Höhe und Breite über einem von Kühlmittel durchflossenen Grundgehäuse aufweisen, die den jeweiligen Abmessungen der Leistungsmodule entspricht.

6. Kühlvorrichtung nach einem der vorangehenden Ansprüche, **dadurch gekennzeichnet**, das die Kühlrippen (14) innen hohl zur Aufnahme eines mit einem Flüssigkeitsgänge bildenden Reliefs versehenen Einschubblättchen versehen sind, zur Zwangsführung von Kühlmittel durch die Rippen.

7. Kühlvorrichtung nach einem der vorangehenden Ansprüche, **dadurch gekennzeichnet**, das die jeweils letzten einer Reihe benachbarter Kühlrippen mit Querversteifungsrippen zur Aufnahme von Klemmkräften der Leistungsmodule zwischen den Rippen versehen sind.

8. Kühlvorrichtung nach einem der vorangehenden Ansprüche, **dadurch gekennzeichnet**, das zwischen je zwei Kühlrippen neben den Leistungsmodulen vorgesehenen Keile zur Klemmbefestigung gekapselter Leistungsmodule mit einer Federwirkung zur Bewirkung eines elastischen Daueranpreßdrucks vorgesehen sind.

9. Kühlvorrichtung nach einem der vorangehenden Ansprüche, **dadurch gekennzeichnet**, das die zwischen je zwei Kühlrippen (14) neben den Leistungsmodulen vorgesehenen Keile zur Klemmbefestigung gekapselter Leistungsmodule mit einem gemeinsamen Steg versehen sind, der wenigstens eine Blattfeder oder Federzunge zur Bewirkung einer Federwirkung in Einschubrichtung auf wenigstens je einen Keil, zur Bewirkung eines elastischen Daueranpreßdrucks aufweist.

10. Kühlvorrichtung nach Anspruch 8 oder 9, **dadurch gekennzeichnet**, das die zwischen je zwei Kühlrippen (14) neben den Leistungsmodulen vorgesehenen Keile aus einem gut wärmeleitenden Material bestehen.

11. Kühlvorrichtung nach einem der vorangehenden Ansprüche, **dadurch gekennzeichnet, dass** ein mit der rippentragenden Gehäuseschale den Körper der Kühlvorrichtung bildender zweiter schalenartiger Deckel zur parallelen Verteilung des Kühlmittels mit gleicher Eingangstemperatur an alle Kühlrippen einen zentralen mittig auf dem Gehäusedeckel angeordneten ersten durch Kanten vorbestimmten Strömbereich und einen randseitigen, ebenfalls alle Kühlrippen erfassenden zweiten Strömbereich aufweist, wobei durch in den Rippen befindliche dritte Strömbereiche ein Durchströmen aller Rippen mit Kühlmittel bewirkt ist, wobei für alle Kühlrippen gleiche Temperatur des durchströmenden Kühlmittels vorhanden ist.

## Claims

1. Heat sink for cooling a plurality of electrical power modules (16) comprising a thermally conductive body (15) which has channels through which a coolant can flow, **characterized in that**
the body (15) has fin-like cooling elements (14) on one side,
wherein each fin-like cooling element (14) can be thermally conductively connected to at least the top or bottom side of one of the plurality of electrical power modules (16) which are to be cooled, and
the body (15) has coolant supply and discharge lines (31) on another side, it being possible to connect the said coolant supply and discharge lines to the coolant which can flow through the interior of the channels.

2. Cooling apparatus according to Claim 1, **characterized in that** central cooling fins (14) are designed to come into fixed thermally conductive contact both with the top or bottom side of one of the plurality of power modules (16) and also furthermore with a further top or bottom side of an adjacent power module of the plurality of power modules.

3. Cooling apparatus according to Claim 1 or 2, **characterized in that** the power modules are accommodated in a stacked manner oriented parallel to one another, so that the electrical connections of the power modules protrude laterally between the cooling fins (14).

4. Cooling apparatus according to one of the preceding claims, **characterized in that** individual cooling fins (14) are fastened to the cooling apparatus in a removable manner, and are provided with separate coolant in- and outlets.

5. Cooling apparatus according to one of the preceding claims, **characterized in that** the cooling fins (14) have a height and width over a main housing, through which coolant flows, which height and width correspond to the respective dimensions of the power modules.

6. Cooling apparatus according to one of the preceding claims, **characterized in that** the cooling fins (14) are provided such that they are hollow on the inside for the purpose of receiving an insert plate which is provided with a relief which forms liquid paths, for the purpose of forcibly guiding coolant through the fins.

7. Cooling apparatus according to one of the preceding claims, **characterized in that** the respectively last cooling fins of a row of adjacent cooling fins are provided with transverse reinforcing fins for absorbing clamping forces of the power modules between the fins.

8. Cooling apparatus according to one of the preceding claims, **characterized in that** wedges, which are provided next to the power modules between in each case two cooling fins, are provided for fastening encapsulated power modules in a clamping manner with a spring action for creating an elastic continuous contact pressure.

9. Cooling apparatus according to one of the preceding claims, **characterized in that** the wedges, which are provided next to the power modules between in each case two cooling fins (14), for fastening encapsulated power modules in a clamping manner are provided with a common web which has at least one leaf spring or spring tongue for creating a spring action in the insertion direction on at least in each case one wedge, for the purpose of creating an elastic continuous contact pressure.

10. Cooling apparatus according to Claim 8 or 9, **characterized in that** the wedges, which are provided next to the power modules between in each case two cooling fins (14), are composed of a highly thermally conductive material.

11. Cooling apparatus according to one of the preceding claims, **characterized in that** a second shell-like cover, which forms the body of the cooling apparatus together with the fin-supporting housing shell, has, for the purpose of parallel distribution of the coolant at the same input temperature to all of the cooling fins, a central first flow region, which is arranged centrally on the housing cover and is predetermined by edges, and an edge-side second flow region, which likewise includes all of the cooling fins, wherein flow of coolant through all of the fins is created by third flow regions which are located in the fins, wherein the through-flowing coolant is at the same temperature for all of the cooling fins.

## Revendications

1. Radiateur destiné à refroidir une pluralité de modules de puissance électriques (16), comprenant un corps thermoconducteur (15) qui possède des canaux dans lequel peut circuler un fluide de refroidissement, **caractérisé en ce que**
le corps (15) possède d'un côté des éléments de refroidissement (14) en forme d'ailettes,
chaque élément de refroidissement (14) en forme d'ailette pouvant être relié en conduction thermique à au moins le côté supérieur ou inférieur de l'un parmi la pluralité de modules de puissance électriques (16) à refroidir, et
le corps (15) possédant d'un autre côté des conduites d'arrivée et de départ de fluide de refroidissement (31) qui peuvent être mises en liaison avec le fluide de refroidissement qui peut circuler à l'intérieur des canaux.

2. Dispositif de refroidissement selon la revendication 1, **caractérisé en ce que** des ailettes de refroidissement centrales (14) sont configurées pour entrer en contact thermoconducteur fixe à la fois avec le côté supérieur ou inférieur de l'un parmi la pluralité de modules de puissance (16) et en plus avec un autre côté supérieur ou inférieur d'un module de puissance voisin parmi la pluralité de modules de puissance.

3. Dispositif de refroidissement selon la revendication 1 ou 2, **caractérisé en ce que** les modules de puissance sont orientés parallèlement les uns aux autres, logés à la manière d'une pile, de sorte que les bornes électriques des modules de puissance font saillie latéralement entre les ailettes de refroidissement (14).

4. Dispositif de refroidissement selon l'une des revendications précédentes, **caractérisé en ce que** des ailettes de refroidissement (14) individuelles sont fixées de manière amovible au dispositif de refroidissement et sont pourvues d'entrées et de sorties de fluide de refroidissement séparées.

5. Dispositif de refroidissement selon l'une des revendications précédentes, **caractérisé en ce que** les ailettes de refroidissement (14) possèdent une hauteur et une largeur, au-dessus d'un boîtier de base traversé par un fluide de refroidissement, qui correspondent aux dimensions respectives des modules de puissance.

6. Dispositif de refroidissement selon l'une des revendications précédentes, **caractérisé en ce que** les ailettes de refroidissement (14) sont pourvues creuses à l'intérieur pour la réception d'une lamelle à insérer munie d'un relief formant des passages à liquide, pour le guidage forcé du fluide de refroidissement à travers les ailettes.

7. Dispositif de refroidissement selon l'une des revendications précédentes, **caractérisé en ce qu'**à chaque fois les dernières ailettes de refroidissement voisines d'une rangée sont munies d'ailettes de renforcement transversales destinées à recevoir les forces de serrage des modules de puissance entre les ailettes.

8. Dispositif de refroidissement selon l'une des revendications précédentes, **caractérisé en ce qu'**entre deux ailettes de refroidissement respectives, à côté des modules de puissance, se trouvent des clavettes destinées à la fixation par serrage des modules de puissance encapsulés avec un effet de ressort pour appliquer une pression d'appui continue élastique.

9. Dispositif de refroidissement selon l'une des revendications précédentes, **caractérisé en ce que** les clavettes destinées à la fixation par serrage des modules de puissance encapsulés qui se trouvent respectivement entre deux ailettes de refroidissement (14) à côté des modules de puissance sont pourvues d'un élément jointif commun qui possède au moins un ressort à lame ou une languette flexible pour appliquer un effet de ressort dans le sens de l'insertion sur au moins une clavette respective, en vue d'appliquer une pression d'appui continue élastique.

10. Dispositif de refroidissement selon la revendication 8 ou 9, **caractérisé en ce que** les clavettes qui se trouvent respectivement entre deux ailettes de refroidissement (14) à côté des modules de puissance sont constituées d'un matériau bon conducteur thermique.

11. Dispositif de refroidissement selon l'une des revendications précédentes, **caractérisé en ce qu'**un deuxième couvercle de type coque, formant le corps du dispositif de refroidissement avec la coque de boîtier qui supporte les ailettes est destiné à la distribution parallèle du fluide de refroidissement à toutes les ailettes de refroidissement avec une température d'entrée identique, possède une première zone d'écoulement prédéfinie par des arêtes, disposée de manière centrale au centre sur le couvercle de boîtier, et une deuxième zone d'écoulement côté bord, elle aussi englobant toutes les ailettes de refroidissement, un courant de fluide de refroidissement qui traverse toutes les ailettes étant produit par les troisièmes zones d'écoulement qui se trouvent dans les ailettes, la même température du fluide de refroidissement en circulation étant présente pour toutes les ailettes de refroidissement.
